# EUROPÄISCHE PATENTSCHRIFT

(11) **EP 4 019 778 B1**
(45) Veröffentlichungstag und Bekanntmachung des Hinweises auf die Patenterteilung: **01.01.2025**
(21) Anmeldenummer: 21206929.8
(22) Anmeldetag: 08.11.2021
(51) Int. Cl.: F04D 13/06, H02K 5/22, F04D 1/00

(54) **ELEKTRONISCHES ERWEITERUNGSMODUL EINER PUMPENELEKTRONIK**
ELECTRONIC EXTENSION MODULE FOR PUMP ELECTRONICS
MODULE ÉLECTRONIQUE D'EXTENSION D'UNE ÉLECTRONIQUE DE POMPE

(30) Priorität: 23.12.2020 LU 102364
(43) Veröffentlichungstag der Anmeldung: 29.06.2022
(60) Teilanmeldung: 22184739.5
(73) Patentinhaber: WILO SE, 44263 Dortmund (DE)
(72) Erfinder: Karns, Stephan, 44263 Dortmund (DE); Brockmann, Markus, 44263 Dortmund (DE); Bencak, Daniel, 44263 Dortmund (DE); Kefenbaum, Arno, 44263 Dortmund (DE); Starkmuth, Timo, 44263 Dortmund (DE); Bouilly, Hervé, 44263 Dortmund (DE); Terrien, Franck, 44263 Dortmund (DE); Nowak, Dirk, 44263 Dortmund (DE); Kleine-Rumberg, Peter, 44263 Dortmund (DE)
(74) Vertreter: Cohausz Hannig Borkowski Wißgott

(56) Entgegenhaltungen:
- EP-A1- 0 351 272
- EP-A1- 2 975 738
- EP-A1- 3 404 267
- WO-A1-2007/012925

## Beschreibung

Die Erfindung betrifft ein elektronisches Erweiterungsmodul einer Pumpenelektronik einer Kreiselpumpe zur Erweiterung der Pumpenelektronik mit wenigstens einer Zusatzfunktion.

Funktionsmodule zur Erweiterung des Funktionsumfangs eines Kreiselpumpenaggregats sind bekannt. Beispielsweise bietet die WILO SE unter der Artikelnummer 2097810 ein Funktionsmodul, auch IF-Modul genannt (IF= Interface), für deren Kreiselpumpenaggregate der Baureihe Stratos und vom Typ Trockenläufer an, das die Steuerungselektronik der Pumpe um eine serielle Kommunikationsschnittstelle für BACnet erweitert, um die Kreiselpumpe an eine Gebäudeautomation anschließen zu können. Das IF-Modul stellt sowohl den elektrischen Anschluss (RS485) für die Anbindung der Pumpe an ein BACnet als auch das notwendige Kommunikationsprotokoll bereit. Ein ebensolches Funktionsmodul bietet die WILO SE unter der Artikelnummer 2097808 an, das eine entsprechende Erweiterung der Pumpe durch den Industriestandard MODBUS erreicht. Somit kann ein Nutzer das Kreiselpumpenaggregat wahlweise ergänzen und gezielt an seine Bedürfnisse und die örtliche Kommunikationsinfrastruktur anpassen. Die beiden Funktionsmodule werden an dieselbe elektrische Schnittstelle des Kreiselpumpenaggregats angesteckt. Das Dokument EP 2 975 738 A1 zeigt ebenfalls ein steckbares elektronisches Erweiterungsmodul.

Aktuellen und zukünftigen Kundenbedürfnissen nachzukommen, erfordert eine stetige Zunahme des Funktionsumfangs von Kreiselpumpenaggregaten respektive ihrer Pumpenelektronik, vor allem im Hinblick auf kabelgebundene oder kabellose Kommunikationsschnittstellen. Da sich bestehende Kommunikationstechnologien zunehmend weiterentwickeln (Beispiel Mobilfunk: 2G(GSM)→3G (UMTS)->4G (LTE Advanced)→5G; Bluetooth→Bluetooth Low Energy) und neue Technologien (ZigBee, enOcean, RFID) hinzukommen, besteht außerdem das Verlangen nach einer schnellen Verfügbarkeit funktionserweiterter Kreiselpumpenaggregate am Markt, dem aufgrund der notwendigen Produktentwicklungszeit und insbesondere der erforderlichen Produktzertifizierung, vor allem bei funkbasierten Kommunikationstechnologien, nur schwer nachgekommen werden kann. Hinzukommt der Wunsch, trotz Funktionszuwachs kostengünstig zu sein.

Eine alle diese Forderungen erfüllende Lösung besteht darin, Funktionen oder Funktionsgruppen modulweise oder baukastenartig in Form von elektronischen Erweiterungsmodulen zur Verfügung zu stellen, die das Hauptprodukt bzw. das Kreiselpumpenaggregat respektive dessen Pumpenelektronik ergänzen. Dies reduziert die Entwicklungszeit und die Dauer bis zur Verfügbarkeit am Markt, weil sich die Entwicklung im Wesentlichen auf die elektronischen Erweiterungsmodule beschränken kann. Ferner ist keine Neuzertifizierung des Hauptprodukts erforderlich, da sich die Zertifizierung auf die elektronischen Erweiterungsmodule beschränkt. Somit können neue Technologien zeitnah mit dem Hauptprodukt kombiniert bzw. dort integriert werden. Da mit Erweiterungsmodulen ferner eine bedarfsgerechte, gezielte Bestückung des Hauptprodukts mit bestimmten Funktionen oder Funktionsgruppen realisierbar ist, können nicht benötigte Funktionalitäten in diesem entfallen, so dass insgesamt ein Kostenvorteil vorliegt.

Die Externalisierung von Funktionen oder Funktionsgruppen in elektronische Erweiterungsmodule stellt jedoch gewisse Ansprüche an die elektrische Schnittstelle zwischen dem elektronischen Erweiterungsmodul und der Pumpenelektronik sowie an die Anordnung bzw. Montage des Erweiterungsmoduls. Dabei sind unter anderem die Aspekte Betriebssicherheit, Robustheit, Fehleranfälligkeit, Berührungsschutz, Isolation, Dichtheit, Handhabung und Befestigung zu berücksichtigen. Ferner ist eine einheitliche Schnittstelle für unterschiedliche Erweiterungsmodule wünschenswert, so dass je nach Bedarf unterschiedliche Erweiterungsmodule an dieselbe elektrische Schnittstelle der Pumpenelektronik angeschlossen werden können.

Es ist deshalb Aufgabe der vorliegenden Erfindung, ein elektronisches Erweiterungsmodul für eine Pumpenelektronik einer Kreiselpumpe zur Erweiterung der Pumpenelektronik mit mindestens einer Zusatzfunktion zur Verfügung zu stellen, das den vorgenannten Forderungen und Wünschen Rechnung trägt.

Diese Aufgabe wird durch ein elektronisches Erweiterungsmodul mit den Merkmalen des Anspruchs 1 gelöst. Vorteilhafte Weiterbildungen sind in den Unteransprüchen angegeben und werden nachfolgend angesprochen.

Erfindungsgemäß wird ein steckbares Erweiterungsmodul einer Pumpenelektronik einer Kreiselpumpe zur Erweiterung der Pumpenelektronik mit mindestens einer Zusatzfunktion vorgeschlagen, umfassend
- ein Gehäuse, das mittels wenigstens einem Verbindungsmechanismus außen an einem Gehäuse der Pumpenelektronik befestigbar ist,
- eine in dem Gehäuse untergebrachte, die Zusatzfunktion bereitstellende Elektronik, und
- eine mit der Elektronik leitungsverbundene elektrische Schnittstelle zum steckbaren elektrischen Verbinden des Erweiterungsmoduls mit der Pumpenelektronik, die auf der zur Pumpenelektronik gerichteten Unterseite des Gehäuses vorsteht, um bestimmungsgemäß durch eine Öffnung im Pumpenelektronikgehäuse hindurch gesteckt zu werden, wobei die elektrische Schnittstelle Kontakte in Form von Leiterbahnen auf einem flachen Trägerelement aufweist, das beabstandet zur Unterseite des Gehäuses zungenartig aus einem Sockel hervorsteht.

Das vorgenannte Erweiterungsmodul ist aufgrund seiner Steckbarkeit besonders einfach zu handhaben und erfüllt auch im Übrigen die Anforderungen an Betriebssicherheit, Robustheit, Fehleranfälligkeit, Berührungsschutz, Isolation und Dichtheit.

Die Zusatzfunktion kann beispielsweise eine funkbasierte Kommunikationstechnologie sein. Diese Kommunikationstechnologie kann zum Beispiel Bluetooth, insbesondere Bluetooth Low Energy (BLE), WLAN (Wireless Local Area Network gemäß IEEE 802.11 Standard) oder Mobilfunk (nach einem Mobilfunkstandard für 3G, 4G, 5G Mobilfunknetze der 3GPP, insbesondere NB-IoT über LTE und/oder 5G Netze). Dies hat den Vorteil, dass die Kreiselpumpe mit einer funkbasierten Kommunikationsschnittstelle ausgestattet und verwendet werden kann, ohne eine entsprechende Zertifizierung der Pumpenelektronik durchzuführen. Da nur das Erweiterungsmodul mit der funkbasierten Kommunikationstechnologie zertifiziert werden muss, reduziert sich insgesamt die Zeit bis zur Verfügbarkeit neuer Pumpenmodelle am Markt. Dabei ist auch zu berücksichtigen, dass ein Erweiterungsmodul für verschiedene Pumpenmodelle oder -varianten verwendet werden kann und nur einmalig zertifiziert werden muss, während Kreiselpumpen mit integrierter Funkschnittstelle für jede Modellvariante jeweils eine Zertifizierung erfordern.

Die Zusatzfunktion kann alternativ eine kabelgebundene Kommunikationstechnologie sein, insbesondere Modbus, BACnet, LIN-Bus oder Ethernet. Gemäß einer weiteren Alternative kann die Zusatzfunktion eine Sensorik, eine Aktorik oder ein elektronischer Speicherbaustein sein. Die Sensorik kann durch einen oder mehrere Sensoren gebildet sein, beispielsweise zur Erfassung einer Temperatur außerhalb der Kreiselpumpe, der Luftfeuchtigkeit, von Vibrationen (Beschleunigungssensor) der Kreiselpumpe oder von Geräuschen (Mikrofon). Bei der Aktorik kann es sich zum Beispiel um ein Relais handeln, das einen potentialfreien Kontakt zur Verfügung stellt, über den die Pumpenelektronik ein externes Gerät ansteuern kann. Der Speicherbaustein kann z.B. als Datenlogger dienen. So kann die Pumpenelektronik Daten der Kreiselpumpe im Erweiterungsmodul speichern, beispielsweise Betriebsdaten wie Förderhöhe, Förderstrom, Leistungsaufnahme etc., oder Informationen über das Auftreten von Fehlern. Alternativ oder zusätzlich kann der Speicherbaustein Träger einer Betriebskonfiguration oder eines Softwareupdates für die Kreiselpumpe sein, die bzw. das über das Erweiterungsmodul in die Pumpenelektronik übertragen werden kann.

Erfindungsgemäß dient die elektrische Schnittstelle zum steckbaren elektrischen Verbinden des Erweiterungsmoduls mit der Pumpenelektronik. Obgleich dies bereits eine gewisse mechanische Stabilität zwischen Erweiterungsmodul und Pumpenelektronik impliziert, ist es von Vorteil, jegliche Beanspruchung durch mechanische Kräfte, die möglicherweise auf das Gehäuse des Erweiterungsmoduls ausgeübt werden, von den elektrischen Kontakten fernzuhalten, um eine Beeinträchtigung der Kontaktierung oder gar eine Beschädigung der elektrischen Schnittstelle oder der korrespondierenden Schnittstelle seitens der Pumpenelektronik zu vermeiden. Dies wird durch den Verbindungsmechanismus erreicht, der eine ortsfeste Fixierung des Erweiterungsmoduls am Pumpenelektronikgehäuse gewährleistet. Dies erfolgt bestimmungsgemäß an dessen Außenseite, so dass kein Platz für das Erweiterungsmodul im Inneren des Gehäuses vorgesehen werden muss und die Abmessungen des Gehäuses somit klein sein können.

Der Verbindungsmechanismus kann vorzugsweise derart ausgestaltet sein, dass das Erweiterungsmodul lösbar am Gehäuse der Pumpenelektronik befestigt werden, so dass es bei Bedarf auch wieder entfernt werden kann. Es kann gegebenenfalls durch ein anderes Erweiterungsmodul ersetzt werden, sei es aufgrund eines reparaturbedingten Austauschs des Erweiterungsmoduls, einer Funktionsänderung oder eines Funktionsupgrades. So kann das andere Erweiterungsmodul eine andere Funktion, eine zur Funktion des vorherigen Erweiterungsmoduls zusätzliche Funktion oder dieselbe Funktion in modernerer Ausführung (Upgrade) enthalten.

Der Verbindungsmechanismus kann beispielsweise eine Schraubbefestigung mittels wenigstens einer Schraube sein. Um die elektrische Schnittstelle auch gegen ein Drehmoment zu schützen, bilden bevorzugt mindestens zwei Schrauben den Verbindungsmechanismus. Somit wird das Erweiterungsmodul durch den Verbindungsmechanismus auch gegen ein Verdrehen geschützt. Geeigneterweise liegen diese beiden Schrauben unmittelbar neben, insbesondere in einer Flucht mit der elektrischen Schnittstelle. Dies hat den Vorteil, dass das Gehäuse des Erweiterungsmoduls in einer Ausführungsvariante minimale laterale Abmessungen haben kann. Vorzugsweise ist oder sind die Schraube(n) als unverlierbare Schraube(n) ausgebildet, so dass sie nicht von dem Gehäuse des Erweiterungsmoduls getrennt werden kann/ können.

Wie bereits ausgeführt, besteht ein Kernaspekt der Erfindung darin, eine einheitliche elektrische Schnittstelle für unterschiedliche Erweiterungsmodule d.h. Erweiterungsmodule mit unterschiedlichen Zusatzfunktionen bereitzustellen. In Abhängigkeit der jeweiligen Zusatzfunktion oder -funktionen können sich die Erweiterungsmodule nicht nur funktional, sondern auch baulich hinsichtlich ihrer Form und/ oder Abmessungen unterscheiden. So kann es wenigstens ein Erweiterungsmodul mit einer ersten Gehäusegröße und ein Erweiterungsmodul mit einer zweiten Gehäusegröße geben, wobei die zweite Gehäusegröße größer als die erste Gehäusegröße ist. Die Anordnung bzw. der Abstand der beiden Schrauben relativ zur elektrischen Schnittstelle bestimmt die untere Grenze der lateralen Gehäuseabmessungen, wobei diese im Falle einer Anordnung der beiden Schrauben in einer Flucht mit der elektrischen Schnittstelle minimal sein können.

Während bei einem baulich kleinen Erweiterungsmodul Schrauben als Verbindungsmechanismus für eine stabile Halterung genügen würden, ist es für größere Erweiterungsmodule von Vorteil zusätzlich oder zumindest alternativ zur Schraubverbindung einen Verbindungsmechanismus zwischen dem Erweiterungsmodul und dem Gehäuse der Pumpenelektronik vorzusehen, der an Verbindungspunkten wirkt, die einen größeren Abstand zur elektrischen Schnittstelle als die Schrauben haben, insbesondere zu diesen versetzt ist. Vorzugsweise ist der Verbindungsmechanismus ein Formschluss mittels Verriegelungselementen, die von der Unterseite des Gehäuses abstehen, um durch entsprechende Öffnungen im Pumpenelektronikgehäuse hindurch gesteckt zu werden.

Die Verriegelungselemente können block- oder stiftartig von der Unterseite des Gehäuses vorspringen. Ihr Querschnitt kann grundsätzlich beliebig sein, z.B. rund, oval, rechteckig oder quadratisch.

Die Verriegelungselemente können in der Form von Rastelementen ausgebildet sein und die Öffnungen im Pumpenelektronikgehäuse hintergreifen. Hierdurch wird eine Selbstverriegelung bewirkt, so dass bereits das Aufstecken des Erweiterungsmoduls auf das Pumpenelektronikgehäuse eine ortsfeste, stabile Halterung bewirkt. Weitere Schritte zur Befestigung des Erweiterungsmoduls sind somit nicht erforderlich, was die Handhabung besonders einfach gestaltet.

Um die Verbindung der Verriegelungselemente zum Pumpenelektronikgehäuse auf einfache Weise wieder trennen zu können, ist es jedoch von Vorteil, wenn die Verriegelungselemente mittels eines seitens des Pumpenelektronikgehäuses angeordneten Blockierelements in Position gehalten werden, so dass sie nicht mehr entgegen der Aufsteckrichtung des Erweiterungsmoduls aus der Verriegelungsposition entfernt werden können. Zu diesem Zweck können die Verriegelungselemente jeweils eine Ausnehmung zur formschlüssigen Aufnahme des genannten Blockierelements aufweisen. Nach dem Aufstecken des Erweiterungsmoduls auf das Pumpenelektronikgehäuse kann das Blockierelement aus einer Freigabeposition in eine den Formschluss mit den Verriegelungselementen bewirkenden Blockierposition gebracht werden, beispielsweise durch ein Verschieben oder Verschwenken des Blockierelements. Das Blockierelements ist somit seitens des Pumpenelektronikgehäuses verschiebbar oder verschwenkbar angeordnet.

Die Anzahl der Verriegelungselemente kann wenigstens zwei, bevorzugt vier betragen. Idealerweise sind die Verriegelungselemente in einem Rechteck angeordnet, so dass eine symmetrische Halterung des Erweiterungsmoduls am Pumpenelektronikgehäuse erreicht wird.

Vorzugsweise steht wenigstens ein Verriegelungselement weiter von der Unterseite des Gehäuses ab, als wenigstens ein anderes Verriegelungselement. Das weiter von der Unterseite abstehende Verriegelungselement eilt hierdurch beim Aufstecken des Erweiterungsmoduls vor und bildet somit frühzeitig eine Führung, die ein Verkanten oder Verkippen des Erweiterungsmoduls längs zur Fügerichtung verhindert und ein fluchtendes, beschädigungsfreies Einstecken der elektrischen Schnittstelle in die korrespondierende elektrische Gegenschnittstelle der Pumpenelektronik gewährleistet. Die Öffnungen im Pumpenelektronikgehäuse, durch die Verriegelungselemente geführt werden, korrespondieren hinsichtlich Form und Größe ihrer Innenkontur mit der Außenkontur der Verriegelungselemente, so dass ein Formschluss besteht. Idealerweise hat zumindest das weiter von der Unterseite des Gehäuses abstehende Verriegelungselement einen nicht runden Querschnitt, so dass der entsprechende Formschluss ein Verdrehen verhindert.

Um das Einsetzen der Verriegelungselemente in die Öffnungen und damit das Aufstecken des Erweiterungsmoduls weiter zu vereinfachen, können die gehäusefernen freien Enden der Verriegelungselemente abgeschrägt oder konisch sein. Dies gewährleistet eine korrekte Ausrichtung des Erweiterungsmoduls relativ zum Gehäuse der Pumpenelektronik. Ein lateraler Versatz wird kompensiert und das Erweiterungsmodul zentriert.

Erfindungsgemäß bildet die elektrische Schnittstelle einen Stecker. Durch das Hervorstehen des Trägerelements aus einem Sockel, beabstandet zur Unterseite des Gehäuses, erfolgt die Kontaktierung der elektrischen Schnittstelle durch die korrespondierenden Gegenkontakte tief im Inneren des Gehäuses der Pumpenelektronik. Vorzugsweise beträgt der Abstand zwischen dem gehäusefernen freien Ende des Trägerelements und der Unterseite des Gehäuses mindestens 20mm. Dies trägt dazu, dass die Gegenkontakte bei nicht aufgesetztem Erweiterungsmodul gegen Berührung geschützt sind. Weiteren Schutz kann ein Blindstopfen bieten, der bei nicht aufgesetztem Erweiterungsmodul die Öffnung im Pumpenelektronikgehäuse verschließt, durch die die elektrische Schnittstelle eingesteckt wird.

Sinnvollerweise ist die Öffnung im Pumpenelektronikgehäuse, durch die die elektrische Schnittstelle eingesteckt wird, nur geringfügig größer als der Sockel, aus dem der Trägerelement hervorsteht. Um einen hohen Berührungsschutz der Gegenkontakte zu erreichen, können die Breite des Sockels kleiner als 14mm, insbesondere kleiner als 12mm, und/ oder die Dicke des Sockels kleiner als 6mm, insbesondere kleiner als 4,5mm sein.

Dadurch, dass die Kontakte der elektrischen Schnittstelle in Form von Leiterbahnen auf dem flachen Trägerelement ausgebildet sind, nehmen die Kontakte nur wenig Platz ein. Hierdurch kann das Trägerelement insgesamt vergleichsweise schmal ausgeführt werden. Das Trägerelement ragt mit einer Länge aus dem Sockel, die größer ist, als seine Breite, so dass das Trägerelement zungenförmig ist. Als Leiterbahnen sind die Kontakte auf dem Trägerelement ferner lagesicher, so dass sie sich, im Vergleich zu vorstehenden Kontaktstiften, beim Einstecken des Erweiterungsmoduls nicht verbiegen können. Die Leiterbahnen können nur auf einer Flachseite oder auf beiden Flachseiten des Trägerelements ausgebildet sein. Somit kann die elektrische Schnittstelle bedarfsweise mehr oder weniger Kontakte aufweisen, ohne dass ihre Form und Abmessung geändert werden muss.

Vorteilhafterweise umfassen die Kontakte erste elektrische Kontakte zur Bestromung der Elektronik im Inneren des Erweiterungsmoduls und zweite elektrische Kontakte zur Datenübertragung. Die Bestromung des Erweiterungsmoduls erfolgt somit durch die Pumpenelektronik, so dass das Erweiterungsmodul grundsätzlich weder einen zusätzlichen Stromversorgungsanschluss noch eine Batterie benötigt. Allerdings kann in einer Ausführungsvariante aus Sicherheitsgründen eine Batterie im und/ oder ein Stromversorgungsanschluss am Erweiterungsmodul vorhanden sein. Die Datenübertragungskontakte dienen der Übertragung von Daten in Form elektrischer Signale zwischen Erweiterungsmodul und Pumpenelektronik. Je nach Zusatzfunktion kann diese Datenübertragung unidirektional oder bidirektional sein, vom Erweiterungsmodul zur Pumpenelektronik und/ oder umgekehrt.

Es ist von Vorteil, wenn wenigstens einer der elektrischen Kontakte näher an die Kante des freien Endes des Trägerelements herangeführt ist, als die anderen Kontakte, und dieser wenigstens eine elektrische Kontakte ein Massekontakt ist. Dies bewirkt, dass dieser wenigstens eine, kantennahe Kontakt beim Einstecken des Erweiterungsmoduls voreilt und somit elektrisch zuerst kontaktiert wird. Hierdurch können elektrostatische Potentiale abgebaut werden, bevor die Datenübertragungskontakte kontaktiert werden. Das Risiko einer Beschädigung eines elektronischen Bauteils des Erweiterungsmoduls wird dadurch minimiert. Ferner ist in der Elektronik das Massepotential definiert, bevor die übrigen, insbesondere die Datenübertragungskontakte kontaktiert werden.

Vorzugsweise sind zwei der elektrischen Kontakte näher an die Kante des freien Endes des Trägerelements herangeführt, als die übrigen Kontakte, wobei der eine dieser beiden Kontakte ein Massekontakt und der andere ein Versorgungskontakt ist. Zwischen diesen beiden Kontakten besteht dann im bestimmungsgemäßen Betrieb eine Versorgungsspannung (SELV), die die Elektronik des Erweiterungsmoduls versorgt. Hierdurch wird erreicht, dass beim Einstecken des Erweiterungsmoduls eine definierte Spannung in der Elektronik existiert, bevor die Datenübertragungskontakte kontaktiert werden.

In einer Ausführungsvariante kann das Trägerelement eine gedruckte Leiterplatte sein. Es ist somit mit der für Leiterplatten bekannten Technologie einfach und preiswert herstellbar und besitzt nur eine geringe Dicke. Die seitens der Pumpenelektronik zu kontaktierenden Gegenkontakte können in diesem Fall als Platinenrandstecker ausgebildet sein, um das freie Ende des Trägerelements in der Art eines Mundes form- und kraftschlüssig zu umgreifen und gleichzeitig die Kontakte der elektrischen Schnittstelle mittels federnden Gegenkontakten zu berühren. Hierdurch wird eine betriebssichere elektrische Verbindung realisiert.

In einer Ausführungsvariante kann das Gehäuse des Erweiterungsmoduls einen Vergusskörper bildet, in dem die Elektronik vergossen ist. Hierdurch ist die Elektronik gegen Staub und Wasser geschützt, wobei mindestens die Schutzart IP65 erreicht wird. Zusätzlich dient die den Vergusskörper bildende Vergussmasse als Kühlung für die Elektronik, da die von der Vergussmasse umhüllte Elektronik ihre Wärme direkt an die Vergussmasse abgibt. Durch die Umhüllung werden außerdem Vibrationen unmittelbar auf die Elektronik übertragen, so dass keine Resonanz mit einer von den Vibrationen verschiedenen Eigenfrequenz entstehen kann, die möglicherweise elektrische Kontaktstelle und / oder elektronische Bauteile der Elektronik des Erweiterungsmoduls schädigt.

In einer anderen Ausführungsvariante kann das Gehäuse des Erweiterungsmoduls zwei- oder mehrteilig sein und einen hohlen Innenraum begrenzen, in dem die Elektronik eingesetzt einliegt. Beispielsweise besteht das Gehäuse aus zwei aufeinandergesetzten Gehäuseschalen, oder aus einem wannenartigen Bodenteil und einem dieses verschließenden Deckel, oder aus einem Boden und einem diesen abdeckenden, haubenartigen Deckelelement.

Der Sockel, aus dem das Trägerelement hervorsteht, ist zwischen der elektrischen Schnittstelle, genauer gesagt zwischen dem frei zugänglichen Abschnitt des Trägerelements und dem Gehäuse angeordnet. Anders betrachtet, erstreckt sich das Trägerelement durch den Sockel hindurch in den Innenraum des Gehäuses des Erweiterungsmoduls hinein, wo es die Elektronik elektrisch kontaktiert. Der Sockel dient somit zur mechanischen Stabilisierung des Trägerelements.

In einer bevorzugten Ausführungsvariante ist der Sockel mit der Unterseite des Gehäuses einstückig. Mit anderen Worten ist der Sockel Teil des Gehäuses. Somit entfällt die Notwendigkeit der Abdichtung eines Spalts zwischen Sockel und Gehäuse, der in einer Ausführungsvariante vorläge, bei der die Unterseite des Gehäuses eine Öffnung aufweist, durch die die elektrische Schnittstelle samt Sockel hindurchgeführt ist. Die Einstückigkeit von Sockel und Gehäuses verleiht der elektrischen Schnittstelle ferner mehr Stabilität.

Gemäß einer Ausführungsvariante ist der Sockel hohl und das Trägerelement durch den Sockel hindurchgesteckt. Die Montage der Elektronik und des Trägerelements innerhalb des Gehäuses des Erweiterungsmoduls ist somit besonders einfach. Der Sockel dient in diesem Fall als Führung und gewährleistet die korrekte Ausrichtung, parallel zur Fügerichtung.

Vorteilhaft ist es, wenn das Trägerelement in dem Sockel eingegossen, d.h. von dem den Sockel bildenden Kunststoffmaterial umspritzt ist. Somit kann keine Feuchtigkeit und kein Staub entlang dem Trägerelement in das Innere des Gehäuses des Erweiterungsmoduls bzw. umgekehrt des Gehäuses der Pumpenelektronik gelangen. Eine Synergie dieser Ausführungsvariante besteht in Verbindung mit der Umspritzung der Elektronik des Erweiterungsmoduls, da in diesem Fall das Trägerelement und die Elektronik gleichzeitig, d.h. in einem gemeinsamen Verfahrensschritt vergossen werden können.

Vorzugsweise weist der Sockel zumindest an dem der Gehäuseunterseite gegenüberliegenden freien Ende einen nur einfach-symmetrischen, vorzugsweise einen trapezförmigen Querschnitt auf. Dieses im Fachjargon als poka-yoke bezeichnete Prinzip gewährleistet das Einstecken des Erweiterungsmoduls mit korrekter Orientierung und verhindert somit eine fehlerhafte Montage, jedenfalls sofern dies nicht bereits durch den Verbindungsmechanismus erreicht wird.

Um die Öffnung im Gehäuse der Pumpenelektronik abzudichten, kann der Sockel am gehäusenahen Ende einen Dichtring tragen. Im montierten Zustand des Erweiterungsmoduls liegt dieser Dichtring dann an der Innenseite der Öffnung im Pumpenelektronikgehäuse an. Der Dichtring kann beispielsweise an den Sockel angespritzt sein, so dass er ortsfest fixiert ist und weder verrutschen noch verloren gehen kann. Hierzu kann ein Elastomer verwendet werden. In einer Ausführungsvariante kann dieser Kunststoff zusätzlich dazu verwendet werden, den Hohlraum im Sockel auszufüllen und somit den Spalt oder die Spalten zwischen dem Trägerelement und der Innenseite des Sockels dichtend zu verschließen. Zur Verbesserung der Dichtwirkung des Dichtrings kann dieser zwei parallele Dichtlippen aufweisen.

Die Erfindung betrifft des Weiteren eine Kreiselpumpe mit einer Pumpenelektronik und einem erfindungsgemäßen Erweiterungsmodul, das an die Pumpenelektronik angesteckt ist.

Wie bereits erwähnt, kann es wenigstens ein erstes erfindungsgemäßes Erweiterungsmodul mit einer ersten Gehäusegröße und ein zweites erfindungsgemäßes Erweiterungsmodul mit einer zweiten Gehäusegröße geben, wobei die zweite Gehäusegröße größer als die erste Gehäusegröße ist. Genauer betrachtet, ist die Grundfläche der Unterseite des Gehäuses des ersten Erweiterungsmoduls größer als die Grundfläche der Unterseite des Gehäuses des zweiten Erweiterungsmoduls. Gleichwohl sind erfindungsgemäß die elektrischen Schnittstellen dieses ersten und zweiten Erweiterungsmoduls derart identisch, dass wahlweise das erste oder das zweite Erweiterungsmodul an die Pumpenelektronik gesteckt werden kann.

Sinnvollerweise gilt dies auch für den Verbindungsmechanismus, insbesondere die räumliche Anordnung der Verriegelungselemente bezogen auf die elektrische Schnittstelle. Wird der Verbindungsmechanismus beispielsweise durch vier Verriegelungselemente gebildet, können diese in den oder nahe der Ecken der Unterseite des Gehäuses des kleineren ersten Erweiterungsmoduls angeordnet sein, wohingegen bei dem zweiten Erweiterungsmodul aufgrund seinem baulich größeren Gehäuse wenigstens zwei der Verriegelungselemente von den Ecken der Unterseite dieses Gehäuses zurückversetzt sind.

Somit ist Gegenstand der Erfindung auch ein Set bestehend aus wenigstens einem ersten und einem zweiten Erweiterungsmodul der vorgenannten Art, bei dem die Grundfläche der Unterseite des ersten Erweiterungsmoduls größer ist, als die Grundfläche der Unterseite des zweiten Erweiterungsmoduls, jedoch die elektrische Schnittstelle und die räumliche Anordnung der Verriegelungselemente bezogen auf die elektrische Schnittstelle bei den beiden Erweiterungsmodulen identisch ist. Weitere Merkmale, Vorteile, Eigenschaften und Wirkungen der Erfindung werden nachfolgend anhand von Ausführungsbeispielen und der beigefügten Figuren erläutert.

Es sei darauf hingewiesen, dass im Rahmen der vorliegenden Beschreibung die Begriffe "aufweisen", "umfassen" oder "beinhalten" keinesfalls das Vorhandensein weiterer Merkmale ausschließen. Ferner schließt die Verwendung des unbestimmten Artikels bei einem Gegenstand nicht dessen Plural aus.

Es zeigen:
- Fig. 1 bis 4:: ein erfindungsgemäßes Erweiterungsmodul gemäß einer ersten Ausführungsvariante
- Fig. 5 bis 8:: ein erfindungsgemäßes Erweiterungsmodul gemäß einer zweiten Ausführungsvariante

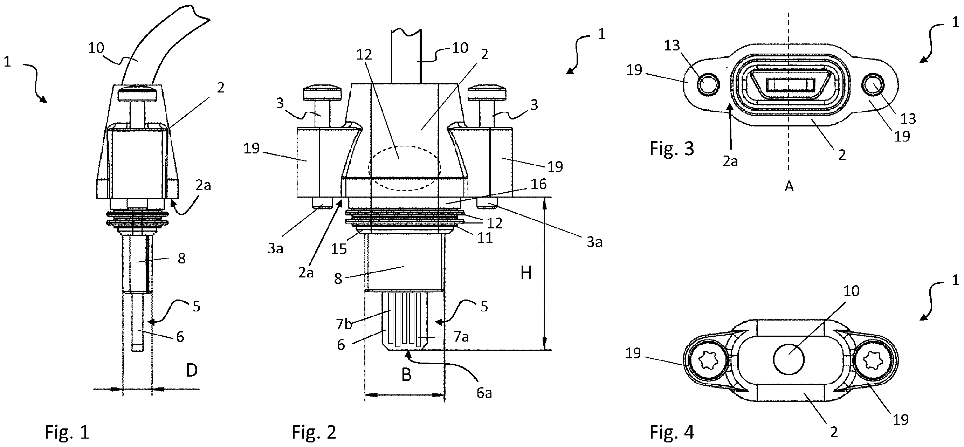

Figur 1 bis 4 zeigen eine erste Ausführungsvariante eines steckbaren elektronischen Erweiterungsmodul 1 einer hier nicht dargestellten Pumpenelektronik einer Kreiselpumpe zur Erweiterung der Pumpenelektronik mit mindestens einer Zusatzfunktion. Dabei stellt Figur 1 eine Seitenansicht, Figur 2 eine Frontalansicht, Figur 3 eine Ansicht von unten und Figur 4 eine Draufsicht dar. Die hier zur Verfügung gestellte Zusatzfunktion ist eine kabelgebundene Busschnittstelle.

Das Erweiterungsmodul 1 umfasst ein Gehäuse 2, das mittels einem Verbindungsmechanismus 3 außen an einem ebenfalls nicht dargestellten Gehäuse der Pumpenelektronik lösbar befestigbar ist. Der Verbindungsmechanismus 3 ist hier in Gestalt einer Schraubverbindung bestehend aus zwei unverlierbaren Schrauben 3 realisiert. Diese liegen in jeweils einer Durchführung oder Bohrung 13 ein, die sich jeweils durch einen Seitenflügel 19 des Gehäuses 2 hindurcherstreckt. In Figur 2 ragt das montageseitige Ende 3a der Schrauben aus dem Gehäuse 2 hervor. Es ist erkennbar, dass der Durchmesser der Schrauben 3 an diesem Ende 3a größer ist, als in dem Abschnitt zwischen dem Gehäuse 2 und dem Schraubenkopf, so dass die Schrauben 3 nicht nach oben aus den Durchführungen 13 entnommen werden können.

Das Erweiterungsmodul 1 weist eine in dem Gehäuse 2 untergebrachte, die Zusatzfunktion bereitstellende Elektronik 12 auf, die hier lediglich angedeutet ist. Die Elektronik 12 umfasst elektrische und / oder elektronische Bauelemente, vorzugsweise auf einer Leiterplatte. Die Elektronik 12 ist in dem Gehäuse 2 vergossen, so dass das Gehäuse einen Vergusskörper bildet. Ein Kabel 10 ist auf der der Pumpenelektronik abgewandten Seite in das Innere des Gehäuses 2 geführt und dort elektrisch mit der Elektronik 12 verbunden. Es ist ebenfalls in dem Gehäuse 2 vergossen.

Das Erweiterungsmodul 1 weist ferner eine mit der Elektronik 12 leitungsverbundene elektrische Schnittstelle 5 zum steckbaren elektrischen Verbinden des Erweiterungsmoduls 1 mit der Pumpenelektronik auf, die von der zur Pumpenelektronik gerichteten Unterseite 2a des Gehäuses 2 vorsteht, um bestimmungsgemäß durch eine Öffnung im Pumpenelektronikgehäuse hindurch gesteckt zu werden. Die elektrische Schnittstelle 5 umfasst Kontakte 7a, 7b in Form von parallelen Leiterbahnen auf einem flachen Trägerelement 6, das hier in der Art einer gedruckten Leiterplatte ausgeführt ist und beabstandet zur Unterseite 2a des Gehäuses 2 zungenartig aus einem Sockel 8 hervorsteht. Die elektrische Schnittstelle 5 bildet somit einen Stecker. Die Leiterbahnen bzw. Kontakte 7a, 7b sind hier auf nur einer Flachseite des Trägerelements 6 ausgebildet, sie können jedoch in einer anderen Ausführungsvariante auf beiden Flachseiten vorhanden sein.

Die Gesamthöhe H zwischen der Unterseite 2a des Gehäuses 2 und dem gehäusefernen Ende des Trägerelements 6 beträgt zwischen 22mm und 23mm. Somit wird erreicht, dass die Kontaktierung der elektrischen Schnittstelle 5 durch korrespondierende Gegenkontakte, vorzugsweise in Gestalt eines Platinenrandsteckers, tief im Inneren des Gehäuses der Pumpenelektronik erfolgt. Der Anteil des Sockels 8 an der Gesamthöhe H beträgt mindestens 50%, vorzugsweise zwischen 60% und 65%.

Wie insbesondere Figuren 1 und 3 zeigen, liegen die beiden Schrauben unmittelbar neben, genauer gesagt in einer Flucht mit der elektrischen Schnittstelle 5. Das Gehäuse 2 ist dadurch insgesamt vergleichsweise klein bzw. schmal.

Die Kontakte 7a, 7b umfassen erste elektrische Kontakte 7a zur Bestromung der Elektronik 12 im Inneren des Erweiterungsmoduls und zweite elektrische Kontakte 7b zur Datenübertragung. Die Bestromung des Erweiterungsmoduls 1 erfolgt somit durch die Pumpenelektronik. Die Datenübertragungskontakte 7b dienen der bidirektionalen Übertragung von Daten in Form elektrischer Signale zwischen Erweiterungsmodul 1 und Pumpenelektronik. Wie in Figur 2 zu erkennen ist, sind die ersten elektrischen Kontakte 7a zur Bestromung der Elektronik 12 näher an die Kante 6a des gehäusefernen Endes des Trägerelements 6 herangeführt, als die Datenübertragungskontakte 7b. Dabei bildet einer der ersten elektrischen Kontakte 7a einen Massekontakt, so dass beim Steckverbinden des Erweiterungsmoduls 1 zunächst die Masse und die Versorgungsspannung (SELV) und erst dann die Datenleitungen verbunden werden.

Die Vorderkante 6a des Trägerelements 6 ist beidseitig sowie an ihren Enden gefast, um das Einsetzen in den Gegenstecker auf der Pumpenelektronik, z.B. den Platinenrandstecker zu erleichtern.

Der Sockel 8 ist einstückig mit dem Gehäuse 2 ausgeführt, so dass es keinen Spalt und keine Naht zwischen Sockel 8 und Gehäuse 2 gibt. Das Trägerelement 6 ist in dem Sockel 8 eingegossen, d.h. von dem den Sockel 8 bildenden Kunststoffmaterial umspritzt. Es erstreckt sich durch den Sockel 8 hindurch in den Innenraum des Gehäuses 2 des Erweiterungsmoduls 1 hinein, wo es die Elektronik 12 elektrisch kontaktiert._Die Breite B des Sockels 8 ist kleiner als 12mm. Ferner beträgt die Dicke D des Sockels 8 weniger als 4,5mm. Das Trägerelement 6 ragt mit einer Länge aus dem Sockel 8, die größer ist, als seine Breite, so dass das Trägerelement 6 insgesamt zungenförmig wirkt.

Der Sockel 8 besteht genau betrachtet aus einem Hauptteil 8, aus dem das Trägerelement 6 hervorragt, einem seitlich, insbesondere allseitig, gegenüber dem Hauptteil 8 vorstehenden Sockelfuß 15, in welchen der Hauptteil 8 Richtung des Gehäuses 2 übergeht, und einer Sockelbasis 16, die seitlich, insbesondere allseitig, gegenüber dem Sockelfuß 15 vorsteht und die Verbindung zwischen Sockelfuß 15 und Gehäuse 2 bildet. Mit anderen Worten geht der Sockelfuß 15 in die Sockelbasis 16 und diese in das Gehäuse 2 über. Der Sockel 8 verbreitert sich in Richtung des Gehäuses 2 somit zweifach und jeweils stufenförmig.

Anhand von Figur 3 wird deutlich, dass der Sockel 8 an seinem gehäusefernen Ende einen nur einfach-symmetrischen Querschnitt besitzt. So besteht lediglich bezüglich einer einzigen Achse A Spiegelsymmetrie. Genauer betrachtet, hat der Hauptteil des Sockels 8 einen im Wesentlichen trapezförmigen Querschnitt, so dass eine einzige Orientierung existiert, um das Erweiterungsmodul 1 an die Pumpenelektronik zu stecken.

Um die Öffnung im Gehäuse der Pumpenelektronik abzudichten, trägt der Sockel 8 am gehäusenahen Ende, genauer gesagt am Außenumfang des Sockelfußes 15 einen Dichtring 11 mit zwei parallele Dichtlippen 12. Der Dichtring 11 reicht bis an den stufenartigen Übergang, an dem der Sockelfuß 15 in die Sockelbasis 16 übergeht. Im montierten Zustand des Erweiterungsmoduls 1 liegt der Dichtring 11 an der Innenseite der Öffnung im Pumpenelektronikgehäuse an.

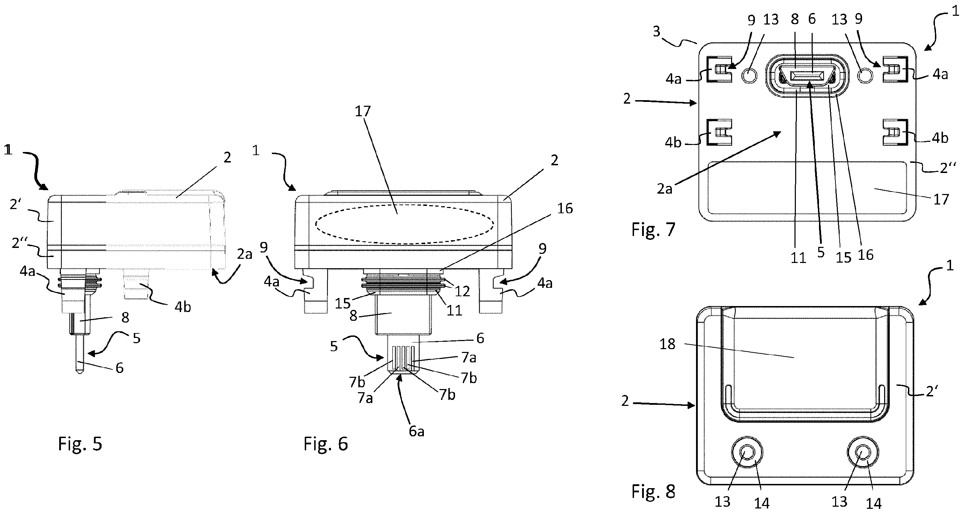

Während Figuren 1 bis 4 ein Erweiterungsmodul 1 mit einer ersten Gehäusegröße zeigen, ist in Figuren 5 bis 8 ein zweites erfindungsgemäßes Erweiterungsmodul 1 mit einer zweiten Gehäusegröße dargestellt, wobei die zweite Gehäusegröße größer als die erste Gehäusegröße ist. Gleichwohl sind die elektrischen Schnittstellen dieser beiden beispielhaften Erweiterungsmodul 1 derart identisch, dass wahlweise das erste oder das zweite Erweiterungsmodul 1 an die dieselbe Schnittstelle der Pumpenelektronik gesteckt werden kann. Figur 5 zeigt eine Seitenansicht, Figur 6 eine Vorderansicht, Figur 7 eine Ansicht von unten und Figur 8 eine Draufsicht des zweiten erfindungsgemäßen Erweiterungsmodul 1. Da die elektrische Schnittstelle 5 einschließlich Sockel 8, 15, 16 und Dichtring 11 identisch sind zur ersten Ausführungsvariante, wird diesbezüglich auf die vorherigen Ausführungen verwiesen. Das zweites erfindungsgemäße Erweiterungsmodul 1 erweitert die Pumpenelektronik durch eine Zusatzfunktion in Gestalt einer Funkschnittstelle, insbesondere Bluetooth, WLAN oder Mobilfunk.

Das Gehäuse 2 ist im Wesentlichen kastenförmig und kommt bestimmungsgemäß außen am Pumpenelektronikgehäuse zum Anliegen. Seine Höhe ist geringer als seine Länge und Breite. Das Gehäuse 2 besteht aus einem Oberteil 2' und einem Unterteil 2", zwischen denen ein hohler Aufnahmeraum gebildet ist, in welchem die Elektronik 12 einliegt. Das Unterteil 2" bildet lediglich einen flachen Boden. Demgegenüber ist das Oberteil 2' haubenartig und deckt die Elektronik 12 ab. Ober- und Unterteil 2', 2" sind formschlüssig, insbesondere rastend miteinander verbunden. Der Sockel 8 ist einstückig mit dem Unterteil 2" ausgebildet. Er ist ebenfalls hohl und das Trägerelement 6 durch den Sockel 8 hindurchgesteckt. Die Montage von Trägerelement 6 und Elektronik 12 erfolgt somit in Fügerichtung des Erweiterungsmoduls 1.

Die Befestigung des Erweiterungsmoduls 1 kann wie bei der ersten Ausführungsvariante mittels zwei Schrauben erfolgen, die in den Figuren 5 bis 8 allerdings nicht dargestellt sind. Das Gehäuse 2 besitzt hierfür ebenfalls entsprechende Durchführungen 13, wie in den Figuren 7 und 8 zu erkennen ist. Im Oberteil 2" sind ringförmige Vertiefungen 14 konzentrisch um die Durchführungen 13 herum vorgesehen, in denen der jeweilige Kopf der Schrauben 3 einliegt, so dass er nicht von der Oberseite des Oberteils 2" hervorragt.

Da das Gehäuse 2 des zweiten Erweiterungsmoduls 1 bei bestimmungsgemäßer Verwendung großflächiger auf dem Pumpengehäuse aufliegt, als das Gehäuse 2 des ersten Erweiterungsmoduls 1, ist zusätzlich zu der möglichen Schraubbefestigung ein weiterer Verbindungsmechanismus zwischen dem Erweiterungsmodul 1 und dem Gehäuse der Pumpenelektronik in Gestalt eines Formschlusses mittels vier Verriegelungselementen 4a, 4b vorgesehen. Diese wirken an Verbindungspunkten, die einen größeren Abstand zur elektrischen Schnittstelle 5 als die optionalen Schrauben 3 haben und die Eckpunkte eines Rechtecks aufspannen. Die Verriegelungselementen 4a, 4b stehen von der Unterseite des Gehäuses 2, genauer gesagt des Unterteils 2" ab, um durch entsprechende Öffnungen im Pumpenelektronikgehäuse hindurch gesteckt zu werden.

Die Verriegelungselemente 4a, 4b springen blockartig von der Unterseite des Gehäuses 2 vor und haben außen einen im Wesentlichen quadratische Querschnitt. Aus Gründen der spritzgusstechnischen Herstellung ist ihr Querschnitt, genauer betrachtet, C-förmig, was die Schwindung des Kunststoffs nach dem Spritzgießen reduziert. Geeigneterweise kann das Gehäuse 2 aus einem thermoplastischen Kunststoff hergestellt sein. Mit zunehmenden Abstand vom Gehäuse 2 verjüngen sich die Verriegelungselemente 4a, 4b in Erstreckungsrichtung in der Art eines Pyramidenstumpfes. Dies erleichtert ihr Einführen in die entsprechenden Öffnungen im Pumpenelektronikgehäuse.

Wie insbesondere Figur 7 zeigt, weisen die Verriegelungselemente 4a, 4b jeweils eine Ausnehmung 9 zur formschlüssigen Aufnahme eines Blockierelements auf, das am Pumpenelektronikgehäuse gehalten ist. Die Ausnehmungen 9 erstrecken sich jeweils quer zur Längserstreckung der Verriegelungselemente 4a, 4b. Sie liegen jeweils auf der der elektrischen Schnittstelle 5 respektive dem Sockel 8 abgewandten Seite der Verriegelungselemente 4a, 4b und öffnen sich jeweils nach außen. Die Ausnehmungen 9 zweier nebeneinanderliegender Verriegelungselemente 4a, 4b fluchten, so dass das Blockierelement linear sein und durch eine Verschiebung in die Ausnehmungen 9 geschoben werden kann, um die Verriegelungselemente 4a, 4b zu arretieren. Mit anderen Worten wird das Blockierelement nach dem Aufstecken des Erweiterungsmoduls auf das Pumpenelektronikgehäuse aus einer Freigabeposition, in der die Öffnungen im Pumpenelektronikgehäuse für die Verriegelungselemente 4a, 4b frei sind, in eine den Formschluss mit den Verriegelungselementen 4a, 4b bewirkenden Blockierposition gebracht, in der sich das Blockierelement in der Flucht der genannten Öffnungen befindet und in den Ausnehmungen 9 einliegt. Somit kann das Erweiterungsmodul 1 nicht mehr entgegen seiner Aufsteckrichtung aus der Verriegelungsposition entfernt werden.

Anhand von Figur 5 ist erkennbar, dass zwei der Verriegelungselemente 4a, genauer betrachtet die sockelnahen Verriegelungselement 4a, weiter von der Unterseite 2a des Gehäuses 2 abstehen, als die anderen, sockelfernen Verriegelungselemente 2b. Die sockelnahen Verriegelungselement 4a eilen hierdurch beim Aufstecken des Erweiterungsmoduls 1 vor und bilden somit frühzeitig eine Führung, um ein Verkanten oder Verkippen der elektrischen Schnittstelle 5 zu verhindern.

Die Unterseite 2a des Gehäuses 2 ist vollständig eben. An der Unterseite 2a ist eine Labelfläche 17 vorgesehen, um beispielsweise ein Etikett oder Typenschild mit technischen Angaben zum Erweiterungsmodul anzuordnen. Die Oberseite des Oberteils 2' besitzt einen Bereich 18, der hier etwas erhaben ist, und vorgesehen ist, um beispielsweise ein Logo aufzunehmen oder ein elektrisches oder elektronisches Anzeigemittel des Erweiterungsmoduls 1 anzuordnen.

Es sei darauf hingewiesen, dass die vorstehende Beschreibung lediglich beispielhaft zum Zwecke der Veranschaulichung gegeben ist und den Schutzbereich der Erfindung keineswegs einschränkt. Der Schutzbereich der Erfindung ist durch die nachfolgenden Ansprüche festgelegt.

### Bezugszeichenliste

- 1: Erweiterungsmodul
- 2: Gehäuse
- 2': Gehäuseoberteil
- 2": Gehäuseunterteil
- 2a: Gehäuseunterseite
- 3: Schraube
- 3a: montageseitige Ende der Schraube
- 4a, 4b: Verriegelungselemente
- 5: Elektrische Schnittstelle
- 6: Trägerelement
- 6a: Kante des Trägerelements
- 7a: erste Kontakte
- 7b: zweite Kontakte
- 8: Sockel
- 9: Ausnehmung
- 10: Kabel
- 11: Dichtring
- 12: Dichtlippe
- 13: Durchführung für Schraube
- 14: Ringförmige Vertiefung
- 15: Sockelfuß
- 16: Sockelbasis
- 17: Labelfläche
- 18: Darstellungsbereich
- 19: Seitenflügel

## Patentansprüche

1. Steckbares elektronisches Erweiterungsmodul (1) einer Pumpenelektronik einer Kreiselpumpe zur Erweiterung der Pumpenelektronik mit mindestens einer Zusatzfunktion, umfassend
- ein Gehäuse (2), das mittels wenigstens einem Verbindungsmechanismus (3, 4a, 4b) außen an einem Gehäuse der Pumpenelektronik befestigbar ist,
- eine in dem Gehäuse (2) untergebrachte, die Zusatzfunktion bereitstellende Elektronik (12), und
- eine mit der Elektronik (12) leitungsverbundene elektrische Schnittstelle (5) zum steckbaren elektrischen Verbinden des Erweiterungsmoduls (1) mit der Pumpenelektronik, die von der zur Pumpenelektronik gerichteten Unterseite (2a) des Gehäuses (2) vorsteht, um bestimmungsgemäß durch eine Öffnung im Pumpenelektronikgehäuse hindurch gesteckt zu werden,
**dadurch gekennzeichnet, dass**
die elektrische Schnittstelle (5) Kontakte (7a, 7b) in Form von Leiterbahnen auf einem flachen Trägerelement (6) aufweist, das beabstandet zur Unterseite (2a) des Gehäuses (2) zungenartig aus einem Sockel (8) hervorsteht.

2. Erweiterungsmodul (1) nach Anspruch 1, **dadurch gekennzeichnet, dass** die Zusatzfunktion eine funkbasierte Kommunikationstechnologie ist, insbesondere Bluetooth, WLAN oder Mobilfunk.

3. Erweiterungsmodul (1) nach Anspruch 1, **dadurch gekennzeichnet, dass** die Zusatzfunktion eine kabelgebundene Kommunikationstechnologie ist, insbesondere Modbus, BACnet, LIN-Bus, Ethernet.

4. Erweiterungsmodul (1) nach Anspruch 1, 2 oder 3, **dadurch gekennzeichnet, dass** die Kontakte (7a, 7b) erste elektrische Kontakte (7a) zur Bestromung der Elektronik und zweite elektrische Kontakte (7b) zur Datenübertragung, insbesondere bidirektionalen Datenübertragung, umfassen.

5. Erweiterungsmodul (1) nach einem der vorherigen Ansprüche, **dadurch gekennzeichnet, dass** der Verbindungsmechanismus (3, 4a, 4b) eine Schraubbefestigung mittels zwei Schrauben (3) ist, die in einer Flucht mit der elektrischen Schnittstelle (5) liegen.

6. Erweiterungsmodul (1) nach einem der vorherigen Ansprüche, **dadurch gekennzeichnet, dass** der Verbindungsmechanismus (3, 4a, 4b) ein Formschluss mittels Verriegelungselementen (4a, 4b) ist, die von der Unterseite (2a) des Gehäuses (2) abstehen, um durch entsprechende Öffnungen im Pumpenelektronikgehäuse hindurch gesteckt zu werden.

7. Erweiterungsmodul (1) nach Anspruch 6, **dadurch gekennzeichnet, dass** die Verriegelungselemente (4a, 4b) jeweils eine Ausnehmung (9) zur formschlüssigen Aufnahme eines insbesondere verschiebbaren Blockierelements aufweisen, das seitens der Pumpenelektronik angeordnet ist.

8. Erweiterungsmodul (1) nach Anspruch 6 oder 7, **dadurch gekennzeichnet, dass** wenigstens ein Verriegelungselement (4a) weiter von der Unterseite (2a) des Gehäuses (2) absteht, als wenigstens ein anderes Verriegelungselement (4b).

9. Erweiterungsmodul (1) nach einem der vorherigen Ansprüche, **dadurch gekennzeichnet, dass** das Gehäuse (2) einen Vergusskörper bildet, in dem die Elektronik (12) vergossen ist.

10. Erweiterungsmodul (1) nach einem der vorherigen Ansprüche, **dadurch gekennzeichnet, dass** der Sockel (8) mit der Unterseite (2a) des Gehäuses (2) einstückig ist.

11. Erweiterungsmodul (1) nach einem der vorherigen Ansprüche, **dadurch gekennzeichnet, dass** der Sockel (8) hohl und das Trägerelement (7) durch den Sockel (8) hindurchgesteckt ist.

12. Erweiterungsmodul (1) nach einem der vorherigen Ansprüche, **dadurch gekennzeichnet, dass** der Sockel (8) zumindest an dem der Gehäuseunterseite (2a) gegenüberliegenden freien Ende einen einfach-symmetrischen, insbesondere trapezförmigen Querschnitt aufweist.

13. Erweiterungsmodul (1) nach einem der vorherigen Ansprüche, **dadurch gekennzeichnet, dass** das Trägerelement (7) eine gedruckte Leiterplatte ist.

14. Erweiterungsmodul (1) nach einem der vorherigen Ansprüche, **dadurch gekennzeichnet, dass** der Sockel (8) am gehäusenahen Ende einen Dichtring (11) trägt, insbesondere mit zwei parallelen Dichtlippen.

15. Erweiterungsmodul (1) nach einem der vorherigen Ansprüche, **dadurch gekennzeichnet, dass** die elektrischen Kontakte (7a, 7b) auf beiden Seiten des Trägerelements (6) angeordnet sind.

16. Erweiterungsmodul (1) nach einem der vorherigen Ansprüche, **dadurch gekennzeichnet, dass** wenigstens einer der elektrischen Kontakte (7a) näher an die Kante (6a) des freien Endes des Trägerelements (6) herangeführt ist, als die anderen Kontakte (7b), und dieser wenigstens eine elektrische Kontakt (7a) ein Massekontakt ist.

17. Erweiterungsmodul (1) nach einem der vorherigen Ansprüche, **dadurch gekennzeichnet, dass** der Abstand (H) zwischen dem gehäusefernen freien Ende des Trägerelements (6) und der Unterseite (2a) des Gehäuses (2) mindestens 20mm beträgt.

18. Kreiselpumpe mit einer Pumpenelektronik und einem Erweiterungsmodul (1) nach einem der vorherigen Ansprüche, das an die Pumpenelektronik angesteckt ist.

19. Set aus wenigstens einem ersten und einem zweiten Erweiterungsmodul (1) nach einem der vorherigen Ansprüche, **dadurch gekennzeichnet, dass** die Grundfläche der Unterseite (2a) des Gehäuses des zweiten Erweiterungsmoduls (1) größer ist, als die Grundfläche der Unterseite (2a) des Gehäuses des ersten Erweiterungsmoduls (1), jedoch die elektrische Schnittstelle (5) und die räumliche Anordnung der Verriegelungselemente (4a, 4b) bezogen auf die elektrische Schnittstelle (5) bei den beiden Erweiterungsmodulen (1) derart identisch sind, dass wahlweise das erste oder das zweite Erweiterungsmodul an die Pumpenelektronik steckbar ist.

## Claims

1. Plug-in electronic extension module (1) for the pump electronics of a centrifugal pump for extension of the pump electronics with at least one additional function, comprising
- a casing (2) that can be attached to the outside of a casing of the pump electronics by means of at least one connecting mechanism (3, 4a, 4b),
- electronics (12) providing the additional function, housed in the casing (2), and
- an electrical interface (5) connected in a circuit with the electronics (12) for the plug-in electrical connection of the extension module (1) with the pump electronics, projecting from the underside (2a) of the casing (2) that faces the pump electronics, for insertion through an opening in the pump electronics casing as intended,
**characterised by** the electrical interface (5) having contacts (7a, 7b) in the form of PCB tracks on a flat carrier (6) that projects as a tongue from a base (8) at a distance from the underside (2a) of the casing (2).

2. Extension module (1) according to claim 1, **characterised by** the additional function being a wireless communication technology, notably Bluetooth, WiFi or mobile radio.

3. Extension module (1) according to claim 1, **characterised by** the additional function being a cable-based communication technology, notably Modbus, BACnet, LIN-Bus or Ethernet.

4. Extension module (1) according to claim 1, 2 or 3, **characterised by** the contacts (7a, 7b) comprising first electrical contacts (7a) to supply power to the electronics and second electrical contacts (7b) for data transmission, notably bidirectional data transmission.

5. Extension module (1) according to one of the preceding claims, **characterised by** the connecting mechanism (3, 4a, 4b) being a screw fastening by means of two screws (3) in line with the electrical interface (5).

6. Extension module (1) according to one of the preceding claims, **characterised by** the connecting mechanism (3, 4a, 4b) being a positive fit by means of locking elements (4a, 4b) that project from the underside (2a) of the casing (2) in order to be inserted through corresponding openings in the pump electronics casing.

7. Extension module (1) according to claim 6, **characterised by** the locking elements (4a, 4b) respectively having a recess (9) for the positively fitting insertion of a blocking element, notably a moveable blocking element, that is arranged on the side of the pump electronics.

8. Extension module (1) according to claim 6 or 7, **characterised by** at least one locking element (4a) projecting farther from the underside (2a) of the casing (2) than at least one other locking element (4b).

9. Extension module (1) according to one of the preceding claims, **characterised by** the casing (2) forming a cast body in which the electronics (12) are encapsulated.

10. Extension module (1) according to one of the preceding claims, **characterised by** the base (8) being of one piece with the underside (2a) of the casing (2).

11. Extension module (1) according to one of the preceding claims, **characterised by** the base (8) being hollow and the carrier (7) being inserted through the base (8).

12. Extension module (1) according to one of the preceding claims, **characterised by** the base (8) having a symmetrical cross-section with one line of symmetry, notably a trapezoidal cross-section, at least on the free end opposite the underside (2a) of the casing.

13. Extension module (1) according to one of the preceding claims, **characterised by** the carrier (7) being a printed circuit board.

14. Extension module (1) according to one of the preceding claims, **characterised by** the base (8) carrying a sealing ring (11) on the end closest to the casing, notably with two parallel sealing lips.

15. Extension module (1) according to one of the preceding claims, **characterised by** the electrical contacts (7a, 7b) being arranged on both sides of the carrier (6).

16. Extension module (1) according to one of the preceding claims, **characterised by** at least one of the electrical contacts (7a) extending closer to the edge (6a) of the free end of the carrier (6) than the other contacts (7b) and this at least one electrical contact (7a) being an earth contact.

17. Extension module (1) according to one of the preceding claims, **characterised by** the distance (H) between the free end of the carrier (6) farthest from the casing and the underside (2a) of the casing (2) being at least 20mm.

18. Centrifugal pump with pump electronics and an extension module (1) according to one of the preceding claims that is plugged into the pump electronics.

19. Set of at least one first and one second extension module (1) according to one of the preceding claims, **characterised by** the base area of the underside (2a) of the casing of the second extension module (1) being larger than the base area of the underside (2a) of the casing of the first extension module (1), but the electrical interface (5) and the spatial arrangement of the locking elements (4a, 4b) being identical with regard to the electrical interface (5) for the two extension modules (1), so that the first or the second extension module can be alternatively plugged into the pump electronics.

## Revendications

1. Module électronique d'extension (1) enfichable d'une électronique de pompe d'une pompe centrifuge pour l'extension du circuit électronique de pompe avec au moins une fonctionnalité supplémentaire, comprenant
- un boîtier (2) pouvant être fixé à l'extérieur d'un boîtier du circuit électronique de pompe par au moins un mécanisme d'assemblage (3, 4a, 4b),
- un circuit électronique (12) logé dans le boîtier (2) et fournissant la fonctionnalité supplémentaire, et
- une interface électrique (5) reliée par conduction au circuit électronique (12) pour la liaison électrique enfichable du module d'extension (1) avec le circuit électronique de pompe, dépassant de la face inférieure (2a) du boîtier (2) orientée vers le circuit électronique de pompe pour être enfichée, conformément à sa destination, à travers une ouverture dans le boîtier d'électronique de pompe,
**caractérisé en ce que** l'interface électrique (5) présente des contacts (7a, 7b) sous forme de pistes conductrices sur un élément porteur plat (6) dépassant à la manière d'une languette hors d'un socle (8) à distance de la face inférieure (2a) du boîtier (2).

2. Module d'extension (1) selon la revendication 1, **caractérisé en ce que** la fonctionnalité supplémentaire est une technologie de communication sans fil, plus particulièrement par Bluetooth, Wi-Fi ou téléphonie mobile.

3. Module d'extension (1) selon la revendication 1, **caractérisé en ce que** la fonctionnalité supplémentaire est une technologie de communication câblée, plus particulièrement par Modbus, BACnet, LIN-Bus ou Ethernet.

4. Module d'extension (1) selon la revendication 1, 2 ou 3, **caractérisé en ce que** les contacts (7a, 7b) comprennent des premiers contacts électriques (7a) pour l'alimentation en courant du circuit électronique et des deuxièmes contacts électriques (7b) pour la transmission de données, en particulier une transmission de données bidirectionnelle.

5. Module d'extension (1) selon l'une des revendications précédentes, **caractérisé en ce que** le mécanisme d'assemblage (3, 4a, 4b) est une fixation par vis au moyen de deux vis (3) alignées avec l'interface électrique (5).

6. Module d'extension (1) selon l'une des revendications précédentes, **caractérisé en ce que** le mécanisme d'assemblage (3, 4a, 4b) est un assemblage par verrouillage de forme au moyen d'éléments de verrouillage (4a, 4b) dépassant de la face inférieure (2a) du boîtier (2) pour être insérés à travers des ouvertures correspondantes dans le boîtier d'électronique de pompe.

7. Module d'extension (1) selon la revendication 6, **caractérisé en ce que** les éléments de verrouillage (4a, 4b) présentent chacun un renfoncement (9) destiné à recevoir avec ajustement de forme un élément de blocage, plus particulièrement coulissant, disposé du côté du circuit électronique de pompe.

8. Module d'extension (1) selon la revendication 6 ou 7, **caractérisé en ce qu'**au moins un élément de verrouillage (4a) dépasse plus loin de la face inférieure (2a) du boîtier (2) qu'au moins un autre élément de verrouillage (4b).

9. Module d'extension (1) selon l'une des revendications précédentes, **caractérisé en ce que** le boîtier (2) forme un corps de scellement dans lequel le circuit électronique (12) est encapsulée.

10. Module d'extension (1) selon l'une des revendications précédentes, **caractérisé en ce que** le socle (8) est solidaire de la face inférieure (2a) du boîtier (2).

11. Module d'extension (1) selon l'une des revendications précédentes, **caractérisé en ce que** le socle (8) est creux et l'élément porteur (7) est inséré à travers le socle (8).

12. Module d'extension (1) selon l'une des revendications précédentes, **caractérisé en ce que** le socle (8) présente, au moins à l'extrémité libre opposée à la face inférieure (2a) du boîtier, une section transversale symétrique simple, plus particulièrement trapézoïdale.

13. Module d'extension (1) selon l'une des revendications précédentes, **caractérisé en ce que** l'élément porteur (7) est une carte de circuit imprimé.

14. Module d'extension (1) selon l'une des revendications précédentes, **caractérisé en ce que** le socle (8) porte à l'extrémité proche du boîtier une bague d'étanchéité (11), plus particulièrement avec deux lèvres d'étanchéité parallèles.

15. Module d'extension (1) selon l'une des revendications précédentes, **caractérisé en ce que** les contacts électriques (7a, 7b) sont disposés de part et d'autre de l'élément porteur (6).

16. Module d'extension (1) selon l'une quelconque des revendications précédentes, **caractérisé en ce qu'**au moins un des contacts électriques (7a) est plus proche du bord (6a) de l'extrémité libre de l'élément porteur (6) que les autres contacts (7b), et que cet au moins un contact électrique (7a) est un contact de masse.

17. Module d'extension (1) selon l'une des revendications précédentes, **caractérisé en ce que** la distance (H) entre l'extrémité libre éloignée du boîtier de l'élément porteur (6) et la face inférieure (2a) du boîtier (2) est d'au moins 20 mm.

18. Pompe centrifuge avec un circuit électronique de pompe auquel est connecté un module d'extension (1) selon l'une des revendications précédentes.

19. Assemblage d'au moins un premier et un second module d'extension (1) selon l'une des revendications précédentes, **caractérisé en ce que** la surface de base de la face inférieure (2a) du boîtier du second module d'extension (1) est plus grande que la surface de base de la face inférieure (2a) du boîtier du premier module d'extension (1), mais l'interface électrique (5) et la disposition spatiale des éléments de verrouillage (4a, 4b) par rapport à l'interface électrique (5) sont identiques pour les deux modules d'extension (1), de telle sorte que le premier ou le second module d'extension peut être enfiché au choix sur le circuit électronique de pompe.
